(19) Europäisches Patentamt

European Patent Office

Office européen des brevets

(11) **EP 0 803 738 B1**

(12) **EUROPÄISCHE PATENTSCHRIFT**

(45) Veröffentlichungstag und Bekanntmachung des Hinweises auf die Patenterteilung:
**02.04.2003 Patentblatt 2003/14**

(51) Int Cl.⁷: **G01R 33/3415**

(21) Anmeldenummer: **97201116.7**

(22) Anmeldetag: **15.04.1997**

(54) **Bild-Synthese-Verfahren zur Erzeugung eines Kombinationsbildes aus Ausgangsbildern**

Method of synthesizing an image for producing a combination image from input images

Méthode de synthèse d'image pour la production d'une image en combinant des images initiales

(84) Benannte Vertragsstaaten:
**DE FR GB NL**

(30) Priorität: **24.04.1996 DE 19616366**
**07.09.1996 DE 19636469**

(43) Veröffentlichungstag der Anmeldung:
**29.10.1997 Patentblatt 1997/44**

(73) Patentinhaber:
• **Philips Corporate Intellectual Property GmbH 20099 Hamburg (DE)**
Benannte Vertragsstaaten:
**DE**
• **Koninklijke Philips Electronics N.V. 5621 BA Eindhoven (NL)**
Benannte Vertragsstaaten:
**FR GB NL**

(72) Erfinder: **Lüdeke, Kai-Michael**
**22335 Hamburg (DE)**

(74) Vertreter: **Volmer, Georg, Dipl.-Ing. et al**
**Philips Corporate Intellectual Property GmbH, Postfach 50 04 42**
**52088 Aachen (DE)**

(56) Entgegenhaltungen:
**EP-A- 0 635 727**

• **P.B. ROEMER ET AL.: "The NMR Phased Array" MAGNETIC RESONANCE IN MEDICINE, Bd. 16, 1990, Seiten 192-225, XP000175903**
• **L.L. WALD ET AL.: "Phased Array Detectors..." MAGNETIC RESONANCE IN MEDICINE, Bd. 34, 1995, Seiten 433-439, XP000527026**
• **M. FUDERER, A. VAN ELST: "Surface Coil Intensity Correction using Homomorphic Filtering" MEETING OF THE SOCIETY OF MAGNETIC RESONANCE, 1987, Seite 266 XP002036197**
• **PATENT ABSTRACTS OF JAPAN vol. 16, no. 110 (C-0920), 18.März 1992 & JP 03 284240 A (TOSHIBA CORP), 13.Dezember 1991,**

**Beschreibung**

Die Erfindung betrifft ein MR-Verfahren nach dem Oberbegriff des Anspruchs 1. Außerdem bertrifft die Erfindung eine Anordnung zur Durchführung dieses Verfahrens.

Ein derartiges MR-Verfahren ist insbesondere bei MR-Untersuchungen anwendbar, bei denen die im Untersuchungsbereich erzeugten MR-Signale von mehreren um den Untersuchungsbereich verteilten Oberflächenspulen aufgenommen werden. Gegenüber einer MR-Untersuchung mit nur einer Empfangsspule, die eine konstante Empfindlichkeit über den gesamten Abbildungsbereich hat, ergibt sich hierbei der Vorteil eines verbesserten Signal-Rausch-Verhältnisses. Allerdings haben solche Oberflächenspulen eine stark ortsabhängige Empfindlichkeit, so daß die für die einzelnen Spulen ermittelten Ausgangsbilder nicht ohne weiteres addiert werden können, um ein den gesamten Untersuchungsbereich optimal darstellendes Kombinationsbild zu erhalten.

Aus einem Aufsatz von Roemer et al in Magn. Reson. Med. 16, 192-225 (1990) ist bereits ein MR -Verfahren der eingangs genannten Art bekannt, bei dem ein Kombinationsbild aus mehreren Ausgangsbildern erzeugt wird nach der Beziehung

$$P_{jk} = p_{jk}^t \, R^{-1} \, b \, b_{jk}^* \qquad (1)$$

Dabei ist

- $P_{jk}$ ein komplexer Bildwert des Kombinationsbildes für einen Bildpunkt, der in der Zeile j und der Spalte k des Kombinationsbildes liegt
- $p_{jk}^t$ die transponierte Form eines Spaltenvektors $p_{jk}$, der sich aus den komplexen Bildwerten der einzelnen Ausgangsbilder für den Bildpunkt jk zusammensetzt,
- $R^{-1}$ die Inverse der sogenannten Rauschkorrelationsmatrix (bei Roemer als "noise resistance matrix" bezeichnet) und
- $b_{jk}^*$ die konjugiert komplexe Form eines Spaltenvektors $b_{jk}$, der sich aus den Werten der Empfindlichkeiten der einzelnen Spulen für den Bildpunkt jk zusammensetzt.

Allerdings macht sich bei den so berechneten Bildwerten $P_{jk}$ des Kombinationsbildes noch immer der Einfluß der ortsabhängigen Empfindlichkeit bemerkbar, was dazu führt, daß die Punkte jk im Kombinationsbild, die am weitesten von den einzelnen Spulen bzw. Spulen entfernt sind, die geringste Helligkeit haben. Der Einfluß der Ortsabhängigkeit der Spulenempfindlichkeiten kann nach Roemer eliminiert werden durch

$$P_{jk} = \frac{p_{jk}^t \, R^{-1} \, b_{jk}^*}{b_{jk}^t \, R^{-1} \, b_{jk}^*} \qquad (2)$$

Dabei ist $b_{jk}^t$ die transponierte Form des Empfindlichkeitsvektors $b_{jk}$.

Bei der Anwendung dieser Berechnungsvorschrift ergibt sich in der Praxis das Problem, daß $b_{jk}$ bzw. die Empfindlichkeit der einzelnen Spulen an den verschiedenen Bildpunkten des Untersuchungsbereichs nicht bekannt ist.

Aus der EP OS 0635 727 ist ein MR-Verfahren bekannt, bei dem die ortsabhängige Empfindlichkeit eines mit einer Oberflächenspule aufgenommenen Ausgangsbildes näherungsweise dadurch ermittelt wird, daß das Ausgangsbild einer Tiefpaßfilterung unterzogen wird. Die Bildwerte dieses Tiefpaßbildes sollen näherungsweise der Empfindlichkeit entsprechen. Durch Division der Bildwerte des Ausgangsbildes durch die Bildwerte dies Tiefpaßbildes soll sich ein Bild ergeben, in dem der Einfluß der ortsabhängigen Empfindlichkeit eliminiert ist. Dies gelingt allerdings nur begrenzt, weil die Empfindlichkeit mit diesem Verfahren nur relativ ungenau bestimmt werden kann.

Aus der EP-OS 695 947 ist ein MR-Verfahren bekannt, bei dem die Empfindlichkeit der einzelnen Oberflächenspulen mit Hilfe einer zusätzlichen Spule bestimmt wird, die für den gesamten Untersuchungsbereich eine näherungsweise konstante Empfindlichkeit aufweist. Dabei werden in zeitlich getrennten Verfahrensschritten für diese Spule einerseits und für die Oberflächenspulen andererseits MR-Bilder erzeugt, und aus dem Verhältnis eines Bildwertes der zusätzlichen MR-Spule zu einem Bildwert einer Oberflächenspule für denselben Bildpunkt wird ein Maß für die Empfindlichkeit der Oberflächenspule in dem betreffenden Bildpunkt abgeleitet. Mit den so gewonnenen komplexen Werten der Empfindlichkeit und den Bildweiten der Ausgangsbilder der einzelnen Spulen erfolgt nach in dieser Veröffentlichung angegebenen Gleichungen eine Synthese zur Erzeugung eines Kombinationsbildes aus den Ausgangsbildern. Nachteilig dabei ist, daß eine zusätzliche MR-Spule und zusätzliche Messungen benötigt werden.

Die Kenntnis des räumlichen Verlaufs der Empfindlichkeit ist auch dann wichtig, wenn es darum geht ein von einem einzigen Sensor aufgenommenes Ausgangsbild so darzustellen, daß sich die ortsabhängige Empfindlichkeit dieses Sensors nicht als ortsabhängiger Helligkeitsunterschied darstellt.

Aufgabe der vorliegenden Erfindung ist es daher, ein Verfahren der eingangs genannten Art so auszugestalten, daß die Empfindlichkeit ohne eine gesonderten Spule mit über den Untersuchungsbereich konstanter Empfindlichkeit und ohne zusätzliche Messungen zuverlässig bestimmt werden kann. Diese Aufgabe wird erfindungsgemäß durch die im Anspruch 1 angegebenen Maßnahmen gelöst.

Bei der Erfindung werden die Empfindlichkeitswerte durch eine Schätzung oder Näherung aus den Ausgangsbildern abgeleitet. Zu diesem Zweck wird an das Ausgangsbild eine glatte Hüllfläche mit niedriger Krümmung konstruiert wird, die auf lokal größten Bildwerten ruht und alle niedrigeren Bildwerte einschließt, wobei aus den Werten auf der Hüllfläche der räumliche Verlauf des Betrages der Empfindlichkeit des zu dem jeweiligen Ausgangsbild gehörigen Sensors abgeleitet wird. Diese Schätzung des Betrages der Empfindlichkeit beruht auf folgenden Überlegungen:

Wenn sich im Untersuchungsbereich ein homogenes Objekt befände, das so beschaffen wäre, daß sich überall ein maximales Signal ergeben würde, dann könnten aus den MR-Signalen Ausgangsbilder abgeleitet werden, deren räumliches Bildwerteprofil unmittelbar dem Profil des Betrages der Empfindlichkeit entsprechen würde. Reale Objekte sind zwar nicht homogen, doch gibt es auch darin einige Volumenelemente, die ein maximales Signal erzeugen, was sich in einem relativen oder absoluten Maximum in dem Bildwerteprofil des damit erzeugten Ausgangsbildes niederschlägt. Diese ungleichmäßig über das Ausgangsbild verteilten Maxima können als vereinzelte Stützstellen (sparse samples) des Empfindlichkeits-profils angesehen werden. Eine glatte Hüllfläche, die einerseits auf diesen Stützstellen ruht und den Verlauf der übrigen Bildwerte mit möglichst niedriger Krümmung folgt - ähnlich einer auf die Stützstellen aufgelegten, glatt gezogenen Zeltplane - ergibt für die Spule, von der das betreffende Ausgangsbild abgeleitet ist, eine angemessen Schätzung seines Empfindlichkeitsprofils (d.h. des Betrages der ortsabhängigen Empfindlichkeit).

Wenn man die komplexen Bildwerte des Kombinationsbildes nach Gleichung (2) ermitteln will, muß man neben den komplexen Bildwerten auch die komplexen Werte der Empfindlichkeit kennen; d.h um eine optimales Kombinationsbild zu erhalten, ist nicht nur die Kenntnis des Betrages der Empfindlichkeit erforderlich, sondern auch die Kenntnis ihrer Phase. Die Phase läßt sich gemäß Anspruch 2 bestimmen und verarbeiten.

Die Schätzung der Phase beruht auf der Überlegung, daß die Phase in dem Ausgangsbild einerseits durch die sich örtlich relativ "langsam" ändernde Phase der Empfindlichkeit bestimmt ist, andererseits aber auch durch relativ "schnelle" lokale, vom Objekt oder vom Rauschen herrührende Phasenvariationen bedingt ist. Durch eine geeignete Tiefpaßfilterung können die schnellen lokalen Phasenvariationen eliminiert werden, so daß in dem tiefpaßgefilterten komplexen Ausgangsbild nur noch der räumliche Verlauf der Phase der Empfindlichkeit verbleibt. Auf diese Weise kann für jeden Bildpunkt im Untersuchungsbereich und für jede Spule Betrag und Phase der Empfindlichkeit zuverlässig angegeben werden.

Nachdem die komplexen Werte der Empfindlichkeit erfindungsgemäß ermittelt worden sind, kann damit und mit den Bildwerten der Ausgangsbilder ein Kombinationsbild erzeugt werden, wie in den beiden eingangs erwähnten Dokumenten im einzelnen erläutert. Eine bevorzugte Weiterbildung der Erfindung ist demgegenüber in Anspruch 3 beschrieben.

Wenn in der in Anspruch 3 angegebenen Gleichung der Wert für σ geeignet gewählt ist, ist der zweite Term im Nenner der Gleichung vernachlässigbar, solange wenigstens eine Spule in dem Bildpunkt jk eine hinreichende Empfindlichkeit hat. Wenn sämtliche Spulen in dem betreffenden Bildpunkt eine unzureichende Empfindlichkeit haben, verhindert der zweite Term im Nenner der angegebenen Gleichung für $P_{jk}$, daß das Rauschen in dem betreffenden Bildpunkt verstärkt wird.

Ein bevorzugtes Verfahren zur Konstruktion der Hüllflächen ist in Anspruch 4 angegeben. Dabei kann man zu Beginn der Iteration die Hüllflächenpunkte mit den Beträgen der Bildwerte der zugehörigen Ausgangsbilder vorgeben. Durch dieses nichtlineare Filterverfahren lassen sich die Empfindlichkeitsprofile der einzelnen Spulen relativ einfach bestimmen.

Der dafür erforderliche Rechenaufwand läßt sich durch die Ausgestaltung nach Anspruch 5 verringern. Statt für ein Ausgangsbild mit 256 x 256 Bildpunkten muß dann die Hüllfläche nur für ein Ausgangsbild von z.B. 32 x 32 Tiefpaßbildpunkten bestimmt werden, wobei jeder Tiefpaßbildpunkt 8 x 8 Bildpunkte des Ausgangsbildes ersetzt.

Wenn man entsprechend der Ausgestaltung nach Anspruch 7 zur Darstellung eines Kombinationsbildes den Realteil seiner Bildwerte heranzieht (anstatt deren Betrag), dann wird das Rauschniveau im Bildhintergrund und in den Bildbereichen mit niedrigem Signal-Rausch-Verhältnis reduziert.

Eine Anordnung zur Durchführung des erfindungsgemäßen MR-Verfahrens ist in Anspruch 8 beschrieben.

Die Erfindung wird nachstehend anhand der Zeichnungen näher erläutert. Es zeigen:

Fig. 1    ein Blockschaltbild eines MR-Untersuchungsgerätes, mit dem die Erfindung ausführbar ist,

Fig. 2     eine schematische Darstellung der dabei benutzten Spulenanordnung

Fig. 3     ein Ablaufdiagramm zur Erläuterung der für die Erzeugung eines Kombinationsbildes erforderlichen Bearbeitungsschritte,

Fig. 4     ein Bildwerteprofil von einer Spule mit örtlich konstanter Empfindlichkeit und

Fig. 5     ein Bildwerteprofil einer Spule mit ortsabhängiger Empfindlichkeit.

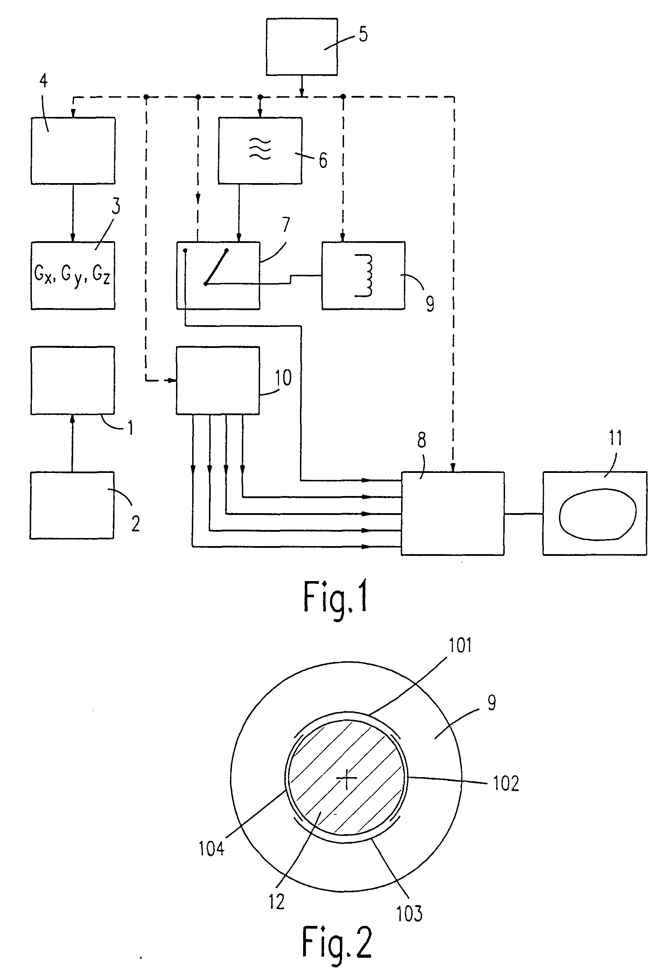

In dem in Fig. 1 schematisch dargestellten Schaltbild ist mit 1 ein vorzugsweise supraleitender Magnet bezeichnet, der in einem Untersuchungsbereich, in dem sich ein Patient befinden kann, ein stationäres homogenes Magnetfeld erzeugt. Der dafür erforderliche Strom wird von einer Einheit 2 geliefert. Mit 3 ist eine Gradientenspulenanordnung bezeichnet, mit der ein magnetisches Gradientenfeld erzeugt werden kann, das in Richtung des stationären Magnetfeldes verläuft und dessen Gradient entweder in der gleichen Richtung oder in zwei dazu und zueinander senkrechten Richtungen verläuft. Die Ströme hierfür werden von einer Treiberschaltung 4 geliefert, wobei der zeitliche Verlauf der Ströme von einer Steuereinheit 5 gesteuert wird, die mittels eines geeignet programmierten Prozessors realisiert werden kann.

Außerdem ist in Hochfrequenzgenerator 6 vorgesehen, der impulsweise Schwingungen mit der Larmorfrequenz des Spinsystems in dem Untersuchungsbereich erzeugen kann. Eine Sende/Empfangsumschalteinheit 7 verbindet eine Ganzkörperspule 9 wahlweise mit einer Empfänger- und Verarbeitungseinheit 8 oder mit dem Hochfrequenzgenerator 6. Die üblicherweise zylinderförmige Ganzkörperspule umschließt bei einer MR-Untersuchung den Körper des Patienten auf einer bestimmten Länge und erzeugt in diesem ein im wesentlichen homogenes Hochfrequenzmagnetfeld. Darüberhinaus ist eine aus mehreren Oberflächenspulen bestehende Oberflächenspulen-Anordnung 10 vorgesehen.

Fig. 2 zeigt die räumliche Lage der Ganzkörperspule 9, bei der es sich z.B. um eine Spule vom Bird-Cage-Typ handeln kann, sowie die aus mehreren (im Beispiel 4) einzelnen Oberflächenspulen 101...104 bestehende Oberflächenspulen-Anordnung. Die vier Oberflächenspulen 101 bis 104 können auf einem nicht näher dargestellten flexiblen Träger angeordnet sein, der um einen zu untersuchenden Patienten 12 herumgewickelt wird. Die Spulen sind dabei so auf dem Träger angeordnet, daß sie sich in einem definierten Bereich überlappen, so daß sich eine gute Entkopplung zwischen benachbarten Oberflächenspulen ergibt. Die Oberflächenspulen 101...104 haben eine örtlich inhomogene Empfindlichkeit, d.h. ein im Zentrum des Untersuchungsobjekts 12 entstehendes MR-Signal ruft in den Spulen einen anderen Strom hervor als ein an der Oberfläche des Untersuchungsobjekts entstehendes MR-Signal gleicher Größe.

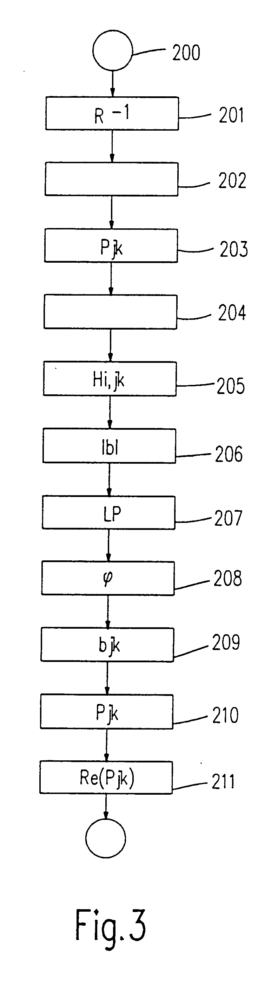

Die Einheit 8 enthält für jede Spule der Oberflächenspulen-Anordnung 10 (sowie für die Ganzkörperspule 9) je einen Kanal, in dem das von der jeweiligen Spule empfangene MR-Signal verstärkt, phasenempfindlich demoduliert und digitalisiert wird. Wegen der phasenempfindlichen Demodulation besteht das digitalisierte Signal für jede Spule aus einer Folge von komplexen (durch Betrag und Phase gekennzeichneten) Abtastwerten, aus denen für jede Spule getrennt ein MR-Ausgangsbild rekonstruiert werden kann, das sich aus komplexen Bildwerten zusammensetzt, die von der Kernmagnetisierungsverteilung und der Empfindlichkeit der Spule in den einzelnen Bildpunkten abhängen. Aus den von den einzelnen Oberflächenspulen erzeugten Ausgangsbildern wird in der Empfänger- und Verarbeitungseinheit 8 ein MR-Kombinationsbild erzeugt und auf einem Monitor 11 wiedergegeben. Wie dies im einzelnen geschieht, soll anhand des in Fig. 3 dargestellten Ablaufdiagramms erläutert werden.

Nach der Initialisierung (200) wird in einem ersten Schritt 201 die Rauschkorrelationsmatrix bzw. die inverse Rauschkorrelationsmatrix $R^{-1}$ ermittelt. Zu diesem Zweck werden die im Untersuchungsbereich erzeugten Signale gemessen, ohne daß mit der Hochfrequenzspule 9 (Fig. 1) Hochfrequenzimpulse erzeugt werden und ohne daß mit der Gradientenspulenanordnung 3 magnetische Gradientenfelder erzeugt werden. Aus diesen Rauschmessungen lassen sich durch Korrelation der verschiedenen Signale die Koeffizienten der Rauschkorrelationsmatrix ableiten, die quadratisch ist und soviel Spalten und Zeilen enthält, wie die Oberflächenspulenanordnung Spulen hat.

Der Schritt 201 kann entfallen, wenn eine Rauschkorrelationsmatrix mit dem zu untersuchenden Objekt bereits gemessen worden ist. Er kann auch grundsätzlich entfallen, wenn man in Kauf nimmt, daß das aus den MR-Ausgangsbildern abgeleitete Kombinationsbild ohne Berücksichtigung der Rauschkorrelationsmatrix ein leicht erhöhtes Rauschen zeigt.

Im nächsten Verfahrensschritt 202 wird die Kernmagnetisierung in dem Untersuchungsbereich durch Sequenzen mit wenigstens einem Hochfrequenzimpuls angeregt und durch magnetische Gradientenfelder räumlich kodiert. Die dabei von den einzelnen Spulen 101...104 empfangenen MR-Signale werden zu komplexen Ausgangsbildern verarbeitet. Aus den so gewonnenen Ausgangsbildern läßt sich für jeden Bildpunkt, der durch die Zeile j und die Spalte k definiert ist, in der er sich befindet, ein Vektor $p_{jk}$ definieren (Schritt 203) gemäß der Beziehung

$$p_{jk} = (P_{1,jk},\ P_{2,jk}\ ,.....P_{n,jk})^t \tag{4}$$

Dabei sind $P_{1,jk}$ ..... $P_{n,jk}$ die komplexen Bildwerte der n-Ausgangsbilder für den betreffenden Bildpunkt.

In den darauffolgenden Verfahrensschritten wird die Empfindlichkeit der einzelnen Spulen in den einzelnen Bildpunkten nach Betrag und Phase geschätzt. Die besten Resultate zeigt das nachfolgend erläuterte Hüllflächen-Konstruktionsverfahren, das davon ausgeht, daß die lokalen (relativen oder absoluten) Maxima in den Bildwerteprofilen Stützstellen der Empfindlichkeitsprofile entsprechen:

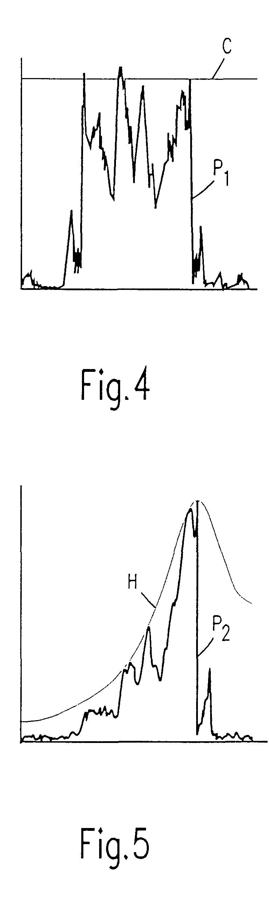

Dies wird im folgenden anhand der Figuren 4 und 5 erläutert, wobei Fig. 4 ein Bildwerteprofil längs einer z.B. in Zeilenrichtung verlaufenden Geraden für das Ausgangsbild einer Spule mit ortsunabhängiger Empfindlichkeit darstellt, während Fig. 5 das Bildwerteprofil eines Ausgangsbildes für eine Spule mit ortsabhängiger Empfindlichkeit zeigt. Das in Fig. 4 dargestellte Bildwerteprofil $P_1$ zeigt mehrere etwa gleichmäßig hohe Maxima im Verlauf der Bildwerte, die von Volumenelementen im Untersuchungsbereich herrühren, in denen das MR-Signal maximal ist. Deshalb ist die Gerade C, die diese Maxima miteinander verbindet, ein Maß für die Empfindlichkeit der Spule. Bei dem in Fig. 5 dargestellten Bildwerteprofil $P_2$ hängt die Höhe der Maxima relativ stark von deren Lage ab. Wenn die Hüllfläche H von diesen Maxima als Stützstellen ausgeht und diese Stützstellen glatt und mit möglichst geringer Krümmung verbindet, dann gibt die Hüllfläche H den räumlichen Verlauf des Empfindlichkeitsprofils der Spule wieder, aus deren MR-Signalen das Ausgangsbild mit dem Bildwerteprofil $P_2$ rekonstruiert wurde.

Für die Rechengeschwindigkeit ist es vorteilhaft, vor der Hüllflächen-Konstruktion in einem Schritt 204 die Zahl der Bildpunkte von z.B 256x256 auf einen geringeren Wert, z.B. 32x32 zu dezimieren, indem eine nichtlineare Tiefpaßfilterung durchgeführt wird, wobei von den Bildwerten, die einem Kernel aus 8 x 8 Bildpunkten zugeordnet sind, der jeweils größte Bildwert selektiert wird und einem Tiefpaßbildpunkt zugeordnet wird, dessen Lage und Größe durch die Bildpunkte des Kernels definiert ist. Auf diese Weise bleiben bei dieser nichtlinearen Filterung die lokalen Maxima der Ausgangsbilder erhalten.

Die Hüllflächen werden dann im Schritt 205 für jedes einzelne der zuvor dezimierten Ausgangsbilder iterativ rekonstruiert, wobei lokal niedrige Bildwerte schnell in Richtung der gewünschten Hüllfläche geringer Krümmung gewachsen, während die lokalen Maxima ihren ursprünglichen Bildwert beibehalten.

Bei diesem nichtlinearen Filterverfahren wird für jeden Punkt $H_{i,jk}$ auf der Hüllfläche ein neuer Wert y berechnet, nach der Beziehung

$$Y = \left( \frac{w\tilde{P}_{i,jk} + 2\sum_{mn=1}^{8} H_{i,mn}}{16 + w} - H_{i,jk} \right) \beta + H_{i,jk} \qquad (10)$$

Dabei ist $\tilde{P}_{i,jk}$ der Bildwert in dem dezimierten Bild, der für den Bildpunkt jk in dem Ausgangsbild der Spule i ermittelt wurde, w ist ein dazu proportionaler oder aber ein konstanter Gewichtungsfaktor, der die Bindung an das Bildwerteprofil $P_2$ (Fig.5) steuert, $H_{i,mn}$ sind die Hüllflächenwerte für die acht Bildpunkte, die den durch jk definierten Bildpunkt umgeben und $\beta$ ist ein Relaxationsfaktor, der zwischen 1 und 1,5 liegen kann. Für den Start des Iterationsverfahrens werden die Hüllflächenwerte zu Beginn den Bildwerten gleichgesetzt.

Wenn der neu berechnete Wert y größer ist als der bisherige Hüllflächenwert $H_{i,jk}$, wird er als neuer Hüllflächenwert $H_{i,jk}$ übernommen; andernfalls werden die Hüllflächenwerte $H_{i,mn}$ der benachbarten Bildpunkte maximal um den Betrag der Differenz von dem bisherigen Wert und dem neu berechneten Wert erhöht, jedoch maximal auf den Wert $\tilde{P}_{i,jk}$, d.h.:

Wenn $y > H_{i,jk}$, dann wird $H_{i,jk} = y$ gesetzt. Andernfalls wird versucht, die Hüllflächenwerte $H_{i,mn}$ für die Nachbarbildpunkte um die Differenz $D = H_{i,jk}-y$ zu erhöhen: Wenn $H_{i,mn} + D$ kleiner ist als $\tilde{P}_{i,jk}$, dann wird $H_{i,mn}$ ersetzt durch $H_{i,mn} + D$; andernfalls wird der Hüllflächenwert $H_{i,mn}$ für den Nachbarbildpunkt ersetzt durch den Bildwert $\tilde{P}_{i,jk}$ für den Bildpunkt jk im Zentrum.

Auf diese Weise werden bei jeder Iteration die Bildwerte aller Bildpunkte bearbeitet, wobei die Bildwerte in den Maxima ihre Größe beibehalten, während sie dazwischen zunehmen. Die Iteration kann beendet werden, wenn das relative Hüllflächenwachstum einen vorgegebenen Wert unterschreitet. Nachdem auf diese Weise die Hüllfläche für eine definierte Anzahl von Bildpunkten errechnet worden ist, wird eine glättende Interpolation durchgeführt, wonach die Hüllfläche für genauso viel Bildpunkte berechnet ist wie in dem Ausgangsbild enthalten waren. In der so gewonnenen Hüllfläche entspricht der Hüllflächenwert $H_{i,jk}$ in guter Näherung dem Betrag $|B_{i,jk}|$ der Empfindlichkeit der Spule, aus deren Bildwerteprofil die Hüllfläche abgeleitet wurde, in dem Bildpunkt jk.

Die nach den Verfahrensweisen a. 1, a.2, a.3 oder b im Schritt 206 ermittelten Beträge $|B_{i,jk}|$ der Empfindlichkeit werden gespeichert.

Danach muß noch die Phase der Empfindlichkeit ermittelt werden. Zu diesem Zweck werden alle Ausgangsbilder einer Tiefpaßfilterung unterzogen (Schritt 207). Dabei wird der Kernel bzw. der Bereich, über den bei der Tiefpaßfilterung gemittelt wird, so groß gewählt, daß Rauschen und vom Objekt verursachte Phasenänderungen unterdrückt werden, andererseits aber klein genug, um der durch die Spulenempfindlichkeit bedingten Phase folgen zu können. Ein in der Praxis bewährter Richtwert sind etwa 10 % der linearen Bildgröße. In dem darauffolgenden Schritt 208 wird für jeden einzelnen Bildpunkt ein Phasenfaktor $e^{j\varphi}$ nach der Beziehung ermittelt

$$e^{j\varphi} \approx \frac{\hat{p}}{|\hat{p}|} \qquad (11)$$

indem jeder komplexe Bildwert $\hat{p}$ dieses Tierpaßbildes durch seinen Betrag dividiert wird.

Danach ist die Empfindlichkeit der einzelnen Spulen in jedem Bildpunkt des Untersuchungsbereichs nach Betrag und Phase bekannt, so daß daraus komplexe Werte für die Empfindlichkeit $B_{i,jk}$ gebildet werden, indem man den auf der Hüllfläche entnehmbaren Betrag $|B_{i,jk}|$ mit dem Phasenfaktor $e^{j\varphi}$ multipliziert, der demselben Bildpunkt und der gleichen Spule zugeordnet ist. Damit wird im Schritt 209 für jeden Bildpunkt jk im Untersuchungsbereich ein Empfindlichkeitsvektor $b_{jk}$ definiert nach der Beziehung

$$b_{jk} = (B_{1,jk}, B_{2,jk}, ..... B_{n,jk})^t \qquad (12)$$

Dabei sind $B_{1,jk}$ ..... $B_{n,jk}$ die komplexen Empfindlichkeitswerte der Spulen 1 bis n für den Bildpunkt jk.

Danach können die komplexen Bildwerte $P_{jk}$ des Kombinationsbildes entsprechend Gleichung (3) berechnet werden (Verfahrensschritt 210). Gegebenenfalls kann diese Berechnung dadurch vereinfacht werden, daß die Rauschkorrelationsmatrix durch die Einheitsmatrix ersetzt wird (wobei die Matrixelemente in der Hauptdiagonalen 1 sind, während alle übrigen Matrixelemente Null sind), was darauf hinausläuft, daß sich die Gleichung (3) vereinfacht zu

$$P_{jk} = \frac{p_{jk}^t\, b_{jk}^*}{b_{jk}^t\, b_{jk}^* + \sigma^2/(b_{jk}^t\, b_{jk}^*)} \qquad (13)$$

Nachdem auf diese Weise die komplexen Bildwerte des Kombinationsbildes ermittelt worden sind, wird anhand dieser Bildwerte das Kombinationsbild auf den Monitor dargestellt, beispielsweise indem für jeden Bildpunkt ein dem Betrag des Bildwertes entsprechender Helligkeitswert ausgegeben wird. Es ist aber auch möglich, statt des Betrages des Bildwertes seinen positiven Realteil darzustellen, wodurch sich das Rauschen im Bildhintergrund in den Bildbereichen mit geringem Signal-Rausch-Verhältnis reduziert.

In dem vorstehend beschriebenen Ausführungsbeispiel wurde ein Kombinationsbild aus den Ausgangsbildern mehrerer Detektoren abgeleitet. Die Erfindung kann aber auch dazu dienen, eine optimale Darstellung aus einem einzigen Ausgangsbild abzuleiten, das von einem Sensor - z. B. einer MR-Spule - aufgenommen wurde. Ohne Bildverbesserung würde die Helligkeit des Ausgangsbildes in gleicher Weise ortsabhängig sein wie die Empfindlichkeit des Detektors. Diese unerwünschte Helligkeitsvariation kann beseitigt werden, wenn die Empfindlichkeit des Sensors in gleicher Weise aus dem Ausgangsbild abgeleitet wird, wie zuvor erläutert. Die Bildwerte $P_{jk}$ für die einzelnen Bildpunkte jk des hinsichtlich Helligkeitswiedergabe und Rauschen optimierten Kombinationsbildes könnten dann entsprechend Gleichung (13) berechnet werden. wobei die "Vektoren" $p_{jk}$ und $b_{jk}$ nur einen einzigen (komplexen) Zahlenwert umfassen würden. Wenn man im ein erhöhtes Rauschen im Bildhintergrund in Kauf nehmen kann ($\sigma = 0$), ergibt sich das optimierte Ausgangsbild, indem man bildpunktweise die Bildwerte des Ausgangsbildes durch die Empfindlichkeit dividiert. In Sonderfällen kann es ausreichen, dabei nur den Betrag der Empfindlichkeit heranzuziehen, sodaß dann auch die Ermittlung der Phase (Schritte 207 und 208) entfallen könnte.

**Patentansprüche**

**1.** MR-Verfahren, bei dem

a) in Anwesenheit eines homogenen stationären Magnetfeldes mindestens eine Sequenz mit wenigstens einem magnetischen Hochfrequenzimpuls auf einen Untersuchungsbereich einwirkt,
b) eine Anzahl von MR-Signalen mit einer mehrere Empfangsspulen umfassenden Empfangsspulen-Anordnung aufgenommen wird, deren Empfindlichkeit über den abzubildenden Bereich variiert,

c) für jede Spule aus den von ihr empfangenen MR-Signalen ein die Kernmagnetisierungs-Verteilung darstellendes Ausgangsbild abgeleitet wird und

d) aus den in Abhängigkeit von der Empfindlichkeit der Spulen gewichteten Bildwerten des Ausgangsbildes oder der Ausgangsbilder ein Kombinationsbild abgeleitet wird,

**dadurch gekennzeichnet, daß** zur Ermittlung der Empfindlichkeit der Spule(n) an das Ausgangsbild eine glatte Hüllfläche mit niedriger Krümmung konstruiert wird, die auf lokal größten Bildwerten ruht und alle niedrigeren Bildwerte einschließt, wobei aus den Werten auf der Hüllfläche der räumliche Verlauf des Betrages der Empfindlichkeit der zu dem jeweiligen Ausgangsbild gehörigen Spule abgeleitet wird.

2. MR-Verfahren nach Anspruch 1,

   a) **dadurch gekennzeichnet, daß**
   b) aus dem Tiefpaß-gefilterten komplexen Ausgangsbild für den zugehörigen Sensor der räumliche Verlauf der Phase der Empfindlichkeit abgeleitet wird,
   c) aus Betrag und der Phase der Empfindlichkeit der einzelnen Sensoren ein komplexer Wert für die Empfindlichkeit gebildet wird.

3. MR-Verfahren nach Anspruch 2,
   **dadurch gekennzeichnet, daß** die Bildwerte $\mathbf{P_{jk}}$ des Kombinationsbildes für einen in der Zeile j und der Spalte k liegenden Bildpunkt nach der Beziehung

$$P_{jk} = \frac{p_{jk}^{t}\, R^{-1}\, b_{jk}^{*}}{b_{jk}^{t}\, R^{-1}\, b_{jk}^{*} + \sigma^{2}/(b_{jk}^{t}\, R^{-1}\, b_{jk}^{*})}$$

berechnet werden, wobei

$\mathbf{p_{jk}}$ ein Spaltenvektor ist, der aus den komplexen Bildwerten des Ausgangsbildes oder der Ausgangbilder für den gleichen, in der Bildpunkt (jk) gebildet ist,

$\mathbf{R^{-1}}$ die inverse Rauschkorrelationsmatrix darstellt,

$\mathbf{b_{jk}}$ ein Spaltenvektor ist, der aus den komplexen Werten der Empfindlichkeit der einzelnen Sensoren an dem gleichen Bildpunkt (jk) gebildet ist,

$b_{jk}^{t}$ und $p_{jk}^{t}$ die transponierte Form der Spaltenvektoren $\mathbf{p_{jk}}$ und $\mathbf{b_{jk}}$

$b_{jk}^{*}$ und $p_{jk}^{*}$ die konjugiert komplexe Form der Spaltenvektoren $\mathbf{p_{jk}}$ und $\mathbf{b_{jk}}$ und

$\sigma$ eine Konstante ist.

4. MR-Verfahren nach Anspruch 1,
   **dadurch gekennzeichnet, daß** die Hüllflächen durch ein aus mindestens zwei aufeinander folgenden Iterationssschritten bestehendes Iterationsverfahren konstruiert werden, indem für jeden Hüllflächenpunkt ($H_{i,jk}$) ein neuer Wert (y) durch ein gewichtetes Mittel aus diesem Punkt und den auf der Hüllfläche liegenden Nachbarpunkten ($H_{i,mn}$) berechnet wird, daß dieser neue Wert (y) aber in die Hüllfläche nur übernommen wird, wenn er größer ist, als der bisherige Wert, daß anderenfalls die Nachbarpunkte ($H_{i,mn}$) maximal um den Betrag der Differenz von bisherigem Wert ($H_{i,jk}$) und dem neuen Wert (y) erhöht werden, jedoch nicht höher als der Bildwert ($\tilde{P}_{i,jk}$) bei Beginn der Iteration.

5. MR-Verfahren nach Anspruch 1 oder 4,
   **dadurch gekennzeichnet, daß** vor der Konstruktion der Hüllflächen die Zahl der Bildpunkte der Ausgangsbilder dezimiert wird, indem ein räumlich zusammenhängender Kernel von Bildpunkten durch einen Bildpunkt mit einem Wert entsprechend dem größten Bildwert innerhalb des Kernels ersetzt wird.

6. Bild-Synthese-Verfahren nach Anspruch 5,
   **dadurch gekennzeichnet, daß** die Hüllflächen nach ihrer Berechnung für eine dezimierte Zahl von Bildpunkten mit einer glättenden Interpolation auf die ursprüngliche Zahl von Bildpunkten gebracht werden.

7. Bild-Synthese-Verfahren nach Anspruch 3,
**dadurch gekennzeichnet, daß** zur Darstellung des Kombinationsbildes der positive Realteil der Bildwerte ($P_{jk}$) herangezogen wird.

8. Anordnung zu Durchführung des Verfahrens nach Anspruch 1, umfassend

a) einen Magneten (1) zur Erzeugung eines homogenen, stationären Magnetfeldes in einem Untersuchungsbereich,
b) eine Gradientenspulenanordnung (3) zur räumlichen Kodierung der Kernmagnetisierung im Untersuchungsbereich durch magnetische Gradientenfelder,
c) eine Hochfrequenzspulenanordnung (9) zur Erzeugung von Hochfrequenzimpulsen im Untersuchungsbereich,
d) eine mehrere Empfangsspulen (101...104) umfassende Empfangsspulen-Anordnung (10) zum Empfang von MR-Signalen aus dem Untersuchungsbereich,
e) programmierbare Verarbeitungsmittel (8) zur Erzeugung Ausgangsbildern aus den von der Empfangsspulen-Anordnung empfangenen MR-Signalen sowie zum Ableiten eines MR-Kombinationsbildes aus den Ausgangsbildern unter Berücksichtigung der komplexen, ortsabhängigen Empfindlichkeit der einzelnen Empfangsspulen (101...104),

**dadurch gekennzeichnet, daß** die Verarbeitungsmittel (8) so programmiert sind, daß an jedes Ausgangsbild eine glatte Hüllfläche mit niedriger Krümmung konstruiert wird, die auf lokal größten Bildwerten ruht und alle niedrigeren Bildwerte einschließt, wobei aus den Werten auf der Hüllfläche der räumliche Verlauf des Betrages der Empfindlichkeit des zu dem jeweiligen Ausgangsbild gehörigen Sensors abgeleitet wird.

## Claims

1. An MR method, in which:

a) at least one sequence which includes at least one magnetic RF pulse acts on an examination zone in the presence of a uniform, steady magnetic field,
b) a number of MR signals is picked up by a receiving coil system which includes a plurality of receiving coils whose sensitivity varies across the zone to be imaged,
c) for each coil a basic image, representing the nuclear magnetization distribution, is derived from the MR signals received by the relevant coil, and
d) a composite image is derived from the image values of the basic image, or of the basic images, weighted in dependence on the sensitivity of the coils,

**characterized in that** a smooth enveloping surface having a slight curvature is constructed on the basic image in order to determine the sensitivity of the coil (coils), which enveloping surface is based on locally highest image values and includes all lower image values, the spatial variation of the absolute value of the sensitivity of the coil associated with the relevant basic image being derived from the values on the enveloping surface.

2. An MR method as claimed in claim 1,

a) **characterized in that**
b) the spatial variation of the phase of the sensitivity is derived from the low-pass filtered complex basic image for the associated sensor,
c) a complex value for the sensitivity is derived from the absolute value and the phase of the sensitivity of the individual sensors.

3. An MR method as claimed in claim 2, **characterized in that** the image values $P_{jk}$ of the composite image are calculated for an image point situated in the row j and the column k in conformity with the relation:

$$P_{jk} = \frac{p_{jk}^{t}\, R^{-1}\, b_{jk}^{*}}{b_{jk}^{t}\, R^{-1}\, b_{jk}^{*} + \sigma^{2}/(b_{jk}^{t}\, R^{-1}\, b_{jk}^{*})}$$

where:

$p_{jk}$      is a column vector which is formed from the complex image values of the basic image or basic images for the same pixel (jk),

$R^{-1}$      is the inverse noise correlation matrix,

$b_{jk}$      is a column vector which is formed from the complex values of the sensitivity of the individual sensors at the same pixel (jk),

$b_{jk}^{t}$ and $p_{jk}^{t}$      are the transposed forms of the column vectors $p_{jk}$ and $b_{jk}$,

$b_{jk}^{*}$ and $p_{jk}^{*}$      are the conjugate complex forms of the column vectors $p_{jk}$ and $b_{jk}$, and

$\sigma$      is a constant.

4. An MR method as claimed in claim 1, **characterized in that** the enveloping surfaces are constructed by means of an iteration method, consisting of at least two successive iteration steps, **in that** for each enveloping surface point ($H_{i,jk}$) a new value (y) is calculated by forming a weighted mean value of this point and the neighboring points ($H_{i,mn}$) situated on the enveloping surface, said new value (y) being taken up in the enveloping surface, however, only if it is larger than the previous value, the neighboring points ($H_{i,mn}$) otherwise being increased by at the most the absolute value of the difference between the previous value ($H_{i,jk}$) and the new value (y), but not beyond the image value ($P^{\sim}_{i,jk}$) at the beginning of the iteration.

5. An MR method as claimed in claim 1 or 4, **characterized in that** prior to the construction of the enveloping surfaces the number of pixels of the basic images is decimated by replacing a spatially coherent kernel of pixels by a pixel having a value which corresponds to the largest image value within the kernel.

6. An image synthesizing method as claimed in claim 5, **characterized in that** after their calculation for a decimated number of pixels, the enveloping surfaces are restored to the original number of pixels by means of a smoothing interpolation.

7. An image synthesizing method as claimed in claim 3, **characterized in that** the positive real component of the image values ($P_{jk}$) is used for the formation of the composite image.

8. An arrangement for carrying out the method claimed in claim 1, which arrangement includes

     a) a magnet (1) for generating a uniform, steady magnetic field in an examination zone,
     b) a gradient coil system (3) for the spatial encoding of the nuclear magnetization in the examination zone by means of magnetic gradient fields,
     c) an RF coil system (9) for generating RF pulses in the examination zone,
     d) a receiving coil system (10) which includes a plurality of receiving coils (101 ... 104) for receiving MR signals from the examination zone,
     e) programmable processing means (8) for generating basic images from the MR signals received by the receiving coil system as well as for deriving an MR composite image from the basic images while taking into account the complex, location-dependent sensitivity of the individual receiving coils (101 ... 104),

**characterized in that** the processing means (8) are programmed in such a manner that on each basic image there is constructed a smooth enveloping surface which has a slight curvature and is based on locally largest image values and includes all lower image values, the spatial variation of the absolute value of the sensitivity of the sensor associated with the relevant basic image being derived from the values on the enveloping surface.

**Revendications**

1.  Procédé R.M.N. dans lequel

    a) en présence d'un champ magnétique stationnaire homogène, au moins une séquence avec au moins une impulsion magnétique à haute fréquence agit sur une zone d'examen,
    b) un nombre de signaux R.M.N. avec un montage de bobines de réception comprenant plusieurs bobines de réception est enregistré, leur sensibilité variant avec la zone à représenter;
    c) pour chaque bobine, une image de sortie représentant la distribution de la magnétisation nucléaire est dérivée des signaux R.M.N. reçus par elle et
    d) à partir des valeurs d'image de la ou des images de sortie pondérées en fonction de la sensibilité des bobines, une image combinée est dérivée,

    **caractérisé en ce que**, pour la détermination de la sensibilité de la ou des bobines, il est construit sur l'image de sortie une surface enveloppante lisse avec une faible courbure qui repose sur les plus grandes valeurs d'image locales et renferme toutes les valeurs d'image inférieures, le tracé spatial du montant de la sensibilité de la bobine appartenant à l'image de sortie respective étant dérivé des valeurs de la surface enveloppante.

2.  Procédé R.M.N. selon la revendication 1,
    **caractérisé** en ce
    le tracé spatial de la phase de la sensibilité est dérivé de l'image de sortie complexe à filtrage passe-bas pour le capteur correspondant,
    à partir du montant et de la phase de la sensibilité des capteurs individuels, une valeur complexe est formée pour la sensibilité.

3.  Procédé R.M.N. selon la revendication 2,
    **caractérisé en ce que** les valeurs d'image $P_{jk}$ de l'image combinée sont calculées pour un point d'image situé sur la ligne j et la colonne k selon l'équation:

    $$P_{jk} = \frac{p_{jk}^{t} \, R^{-1} \, b_{jk}^{*}}{b_{jk}^{t} \, R^{-1} \, b_{jk}^{*} + \sigma^{2}/(b_{jk}^{t} \, R^{-1} \, b_{jk}^{*})}$$

    dans laquelle

    $p_{jk}$ est un vecteur de colonne qui est formé dans le point d'image (jk) à partir des valeurs d'image complexes de la ou des images de sortie pour celle-ci;

    $R^{-1}$ représente la matrice inverse de corrélation du bruit;

    $b_{jk}$ est un vecteur de colonne qui est formé des valeurs d'image complexes de la sensibilité des capteurs individuels sur le même point d'image (jk),

    $b_{jk}^{t}$ et $p_{jk}^{t}$ sont la forme transposée des vecteurs de colonne $p_{jk}$ et $b_{jk}$

    $b_{jk}^{*}$ et $p_{jk}^{*}$ sont la forme complexe conjuguée des vecteurs de colonne $p_{jk}$ et $b_{jk}$ et

    $\sigma$ est une constante.

4.  Procédé R.M.N. selon la revendication 1,
    **caractérisé en ce que** les surfaces enveloppées sont construites par un procédé d'itération composé d'au moins deux étapes d'itération successives, en calculant pour chaque point de surface enveloppante ($H_{i,jk}$) une nouvelle valeur (y) par une moyenne pondérée à partir de ce point et les points voisins ($H_{i,mn}$) situés sur la surface enveloppante, que cette nouvelle valeur (y) n'est toutefois prise en charge que dans la surface enveloppante lorsqu'elle est supérieure à la valeur jusqu'à présent, que, sinon, les points voisins ($H_{i,mn}$) sont majorés au maximum du montant de la différence de la valeur jusqu'à présent ($H_{i,jk}$) et de la nouvelle valeur (y) mais ne dépassent pas la valeur d'image ($P_{i,jk}$) au début de l'itération.

**5.** Procédé R.M.N. selon la revendication 1 ou 4,

**caractérisé en ce que** le nombre de points d'image des images de sortie est décimé avant la construction des surfaces enveloppantes en remplaçant un noyau cohérent spatialement de points d'image par un point d'image avec une valeur correspondant à la plus grande valeur d'image dans le noyau.

**6.** Procédé de synthèse de l'image selon la revendication 5,

**caractérisé en ce qu'**après leur calcul, les surfaces enveloppantes sont amenées pour un nombre décimé de points d'images avec une interpolation lisse au nombre initial de points d'image.

**7.** Procédé de synthèse de l'image selon la revendication 3,

**caractérisé en ce que**, pour la représentation de l'image combinée, la partie réelle positive des valeurs d'image ($P_{jk}$) est utilisée.

**8.** Dispositif de mise en oeuvre du procédé selon la revendication 1, comprenant

a) un aimant (1) pour la production d'un champ magnétique stationnaire homogène dans une zone d'examen,
b) un montage de bobines à gradient (3) pour le codage spatial de la magnétisation nucléaire dans la zone d'examen par des champs à gradient magnétiques;
c) un montage de bobines à haute fréquence (9) pour la production d'impulsions à haute fréquence dans la zone d'examen,
d) un montage de bobines de réception (1à) comprenant plusieurs bobines de réception (101...104) pour la réception de signaux R.M.N. à partir de la zone d'examen,
e) des moyens de traitement programmables (8) pour la production d'images de sortie à partir des signaux R.M.N. reçus par le montage de bobines de réception ainsi que pour dériver une image combinée R.M.N. des images de sortie en prenant en considération la sensibilité complexe dépendant du lieu des bobines de réception (101...104) individuelles,

**caractérisé en ce que** les moyens de traitement (8) sont programmés de telle sorte qu'il soit construit pour chaque image de sortie une surface enveloppante lisse de faible courbure qui repose sur les plus grandes valeurs d'image localement et renferme toutes les valeurs d'image inférieures, le tracé spatial du montant de la sensibilité du capteur appartenant à l'image de sortie respective étant dérivé des valeurs de la surface enveloppante.

Fig.1

Fig.2

Fig.3

Fig. 4

Fig. 5